# EUROPEAN PATENT SPECIFICATION

(11) **EP 3 840 050 B1**
(45) Date of publication and mention of the grant of the patent: **09.03.2022**
(21) Application number: 20197730.3
(22) Date of filing: 23.09.2020
(51) Int. Cl.: H01L 27/30, C25B 1/55, H01L 21/20, H01L 29/267, H01L 51/42, H01L 31/032, H01L 31/078, C25B 1/04, C25B 11/067

(54) **LOW CONTACT RESISTANCE DEVICE AND METHOD OF PRODUCTION**
NIEDRIGES KONTAKTWIDERSTANDS VORRICHTUNG UND PRODUKTIONSVERFAHREN
DISPOSITIF À FAIBLE RÉSISTANCE DE CONTACT ET MÉTHODE DE PRODUCTION

(30) Priority: 17.12.2019 LT 2019085
(43) Date of publication of application: 23.06.2021
(73) Proprietor: Valstybinis Moksliniu Tyrimu Institutas Fiziniu Ir Technologijos Mokslu Centras, 02300 Vilnius (LT)
(72) Inventor: ASMONTAS, Steponas, 08411 Vilnius (LT); GRADAUSKAS, Jonas, 10308 Vilnius (LT); LEINARTAS, Konstantinas, 08413 Vilnius (LT); STAISIUNAS, Laurynas, 10304 Vilnius (LT); SUZIEDELIS, Algirdas, 04207 Vilnius (LT); SILENAS, Aldis, 03221 Vilnius (LT)
(74) Representative: Draugeliene, Virgina Adolfina

(56) References cited:
- WO-A1-2016/090179
- Lin Shijia: "Atomic Layer Deposition (ALD) Process Development of Nb-doped TiO2 as a Transparent Conducting Oxide (TCO) and ALD of HfO2 /Nb2O5 Bilayers as Insulating Barriers for Metal/Insulator/Insulator/Metal (MIIM) Diodes", An abstract of the thesis of Shijia Lin Science in Electrical and Computer Engineering, 16 August 2016 (2016-08-16), XP055780880, Retrieved from the Internet: URL:https://ir.library.oregonstate.edu/con cern/graduate_thesis_or_dissertations/c821 gq16x [retrieved on 2021-03-01]
- V. ZARDETTO ET AL: "Atomic layer deposition for perovskite solar cells: research status, opportunities and challenges", SUSTAINABLE ENERGY & FUELS, vol. 1, no. 1, 1 January 2017 (2017-01-01) , pages 30-55, XP055563141, DOI: 10.1039/C6SE00076B

## Description

### Technical field to which invention relates

The invention relates to the field of electronics associated with the design and manufacturing of semiconductor devices which require low contact resistivity between titanium dioxide (TiO₂) and p-type conductivity semiconductor.

The proposal describes a low resistivity ohmic contact between TiO₂ and a p-type semiconductor and its production method. The contact can be used in tandem semiconductor devices, such as photoelectrodes for electrolysis of water using solar energy, two-terminal perovskite/silicon tandem solar cells, or other devices requiring low contact resistivity between optically transparent and electrically conductive titanium dioxide and p-type semiconductor. The lower the contact resistance, the lower the electrical power loss.

### Indication of the background art

In electronics, titanium dioxide is known as a semiconductor with wide forbidden energy gap (above 3 eV), and is therefore transparent in the visible light spectrum. Most often it has electronic conductivity (n-type). When TiO₂ is deposited on a p-type conductivity semiconductor, a n-p junction is formed, and it demonstrates high, typically reaching several Ω·cm², contact resistivity values.

One way to reduce the TiO₂/p-semiconductor contact resistance is to form a mesoporous TiO₂ interlayer between the crystalline TiO₂ and the semiconductor (patent WO2019210263). This way, localized midgap states are created at the interface of the semiconductor and TiO₂, and these states act as generation-recombination centers facilitating flow of electric current through the contact.

Another way. Prior to the growth of TiO₂, a thin layer of Ti metal is deposited on the semiconductor, and thus a narrow Schottky barrier is created on a semiconductor surface [B. Mei, T. Pedersen, P. Malacrida, D. Bae, R. Frydendal, O. Hansen, PCK Vesborg, B. Seger, I. Chorkendorff, Crystalline TiO2: A Generic and Effective Electron-Conductive Protection Layer for Photoanodes and -cathodes . J. Phys. Chem. Rev. 119, 15019-15027 (2015)]. Electrons can tunnel through the thin barrier. The heavier the doping of the p-semiconductor, the narrower the Schottky barrier, the stronger tunnel current can flow through the contact, and thus the lower is its resistivity.

The closest analogue is a structure containing semiconductor n-p tunnel junction formed by heavy, 10¹⁹-10²⁰ cm⁻³, donor doping of the p-type semiconductor surface, which is then covered with a TiO₂ layer (sections of patent US20160163904). The tunnel junction has low resistivity, and the TiO₂/n-type semiconductor contact between the two n-type semiconductors is an ohmic and has also low resistivity. The shortcoming of the analogue is the requirement of an additional technological operation, i.e., doping of the semiconductor surface, and thus additional outlay and consumption of time. Lin Shijia: "Atomic Layer Deposition (ALD) Process Development of Nb-doped TiO2 as a Transparent Conducting Oxide (TCO) and ALD of HfO2 /Nb2O5 Bilayers as Insulating Barriers for Metal/Insulator/Insulator/Metal (MIIM) Diodes",An abstract of the thesis of

Shijia Lin Science in Electrical and Computer Engineering, 16 August 2016 (2016-08-16), XP055780880,Retrieved from the Internet:URL:https://ir.library.oregonstate.edu/concern/ graduate_thesis_or_dissertations/c821gq16x discloses Atomic Layer Deposition (ALD) of Nb-doped TiO2.

### Technical problem to be solved

The invention aims to reduce the number of technological operations, time and materials by forming a low resistivity contact between TiO₂ and p-type semiconductor.

### Disclosure of invention

According to the present invention a low contact resistivity device comprising a layered structure of heavily doped p-type semiconductor layer and n-type titanium dioxide (TiO₂) layer deposited thereon, wherein a tunnel junction is formed between said layers, wherein the TiO₂ layer is directly by atomic layer deposition (ALD) method deposited on the p-type semiconductor layer, wherein part of the TiO₂ layer adjacent to said p-type semiconductor surface is additionally doped with niobium (Nb) donor impurity during the deposition process, thereby forming the tunnel junction between the n-type TiO₂ layer and p-type semiconductor.

According to the present invention a method for production of low contact resistivity device comprising a layered structure of heavily doped p-type semiconductor layer and n-type titanium dioxide (TiO₂) layer deposited thereon, wherein a tunnel junction is formed between the layers, wherein the TiO₂ layer is directly grown by ALD method onto the surface of the p-type semiconductor layer, wherein to form the tunnel junction, several monoatomic TiO₂ layers and monoatomic niobium (Nb) layer are alternatively grown onto the semiconductor surface thus repeating the alternative growth an intended number of times necessary to reach high level of TiO₂ doping and completing the growth with TiO₂ layer, and then the grown layered structure is annealed in hydrogen atmosphere at temperature of at least 500°C to achieve high conductivity of TiO₂ and to obtain the tunnel junction.

By forming the tunnel junction, the first three monoatomic TiO₂ layers are grown onto the p-type semiconductor surface, then monoatomic Nb layer is grown on them, further five monoatomic TiO₂ layers are grown on it, then monoatomic Nb layer is grown again, and said alternative growing of monoatomic TiO₂ layers and monoatomic Nb layers is repeated an intended number of times.

### Advantages of the invention

Low resistivity contact between p-type semiconductor and n-type titanium dioxide, in comparison with the analogues, has no intermediate layers between TiO₂ and p-type semiconductor, and the process of production involves a lower number of technological operations and requires less materials. The tunnel junction formed across such contact is characterized by low resistivity and linear dependence of electric current on voltage at low voltage values.

### Brief description of drawings

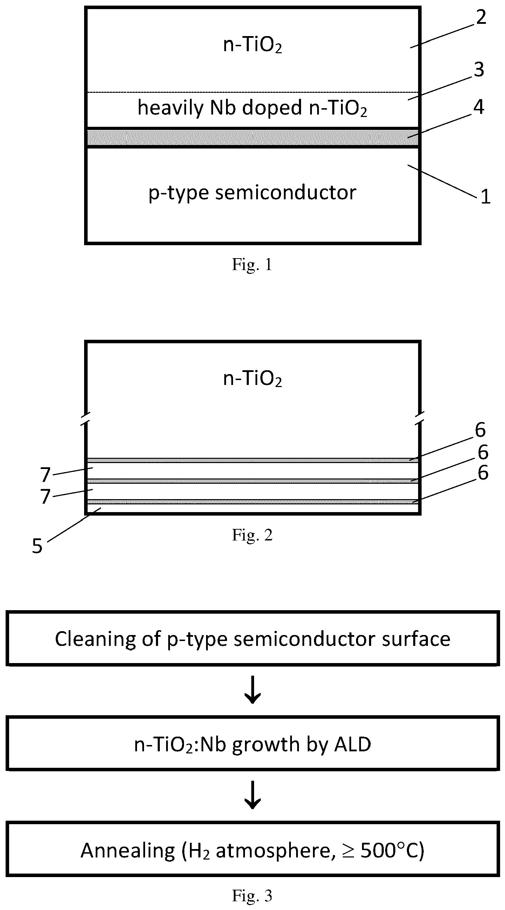

Fig. 1 shows cross-section of low resistivity TiO₂/p-type semiconductor contact;
Fig. 2 shows cross-section of just ALD-deposited TiO₂ layer, before annealing;
Fig. 3 shows fabrication process of low resistivity n-TiO₂/p-type semiconductor contact.

### Example of embodiment of the invention

1 - heavily doped p-type semiconductor, 2 - layer of titanium dioxide, 3 - heavily doped region of TiO₂, 4 - tunnel junction, 5 - first three monoatomic layers of TiO₂, 6 - monoatomic layer of niobium, 7 - five monoatomic layers of TiO₂.

The low contact resistivity device comprises a layer of p-type semiconductor 1, heavily doped not less than up to 10¹⁹ cm⁻³, and a n-type titanium dioxide layer 2 directly deposited by ALD method on the p-type semiconductor 1. Part 3 of the TiO₂ layer adjacent to said p-type semiconductor 1 surface is additionally doped with niobium donor impurity during the deposition process thereby forming a tunnel junction 4 between the additionally doped n-type TiO₂ layer 3 and p-type semiconductor 1.

The method for production of the low contact resistivity device comprising a layered structure of p-type semiconductor layer 1 and n-type titanium dioxide layer 2 deposited thereon with tunnel junction 4 formed between them involves the following sequence of operations. The surface of heavily doped, not less than up to 10¹⁹ cm⁻³, p-type semiconductor 1 is covered by ALD-grown up first three monoatomic layers of TiO₂ 5 on it, then monoatomic Nb layer 6 is grown, on which five monoatomic TiO₂ layers 7 are grown, then monoatomic Nb layer 6 is grown again. The alternative deposition of monoatomic TiO₂ layers 7 and monoatomic Nb layers 6 is repeated an intended number of times necessary to reach high level of doping. Said alternative growth of layers 6 and 7 is completed with TiO₂ layer 2. The whole structure is then placed into a hydrogen atmosphere and annealed at a temperature of at least 500°C, thus forming a high conductivity n-type TiO₂ region 3 which makes a tunnel junction 4 with the adjacent heavily doped p-type semiconductor region 1.

This way, the TiO₂ layer is ALD-deposited directly on the heavily doped (at least to 10¹⁹ cm⁻³) surface of a p-type semiconductor and contains niobium monoatomic layers inserted during the deposition process; niobium, being a donor impurity in titanium dioxide, after annealing together with all the structure at high temperature does not affect transparency of the TiO₂ layer but increases its electrical conductivity due to its high level of doping, thus forming a n-type TiO₂/p-type semiconductor tunnel junction with low resistivity in the low voltage range.

## Claims

1. Low contact resistivity device comprising a layered structure composed of a heavily doped p-type semiconductor layer (1) and an n-type titanium dioxide (TiO₂) layer (2) deposited on it, wherein a tunnel junction (4) is formed between the layers, **characterized in that** the TiO₂ layer (2) is directly deposited onto the p-type semiconductor layer (1) by the atomic layer deposition (ALD) method, wherein part (3) of the TiO₂ layer adjacent to said p-type semiconductor (1) surface is additionally doped with niobium (Nb) donor impurity during the deposition process, thereby forming the tunnel junction (4) between the n-type TiO₂ layer (3) and the p-type semiconductor (1)

2. Method for production of a low contact resistivity device comprising a layered structure composed of a heavily doped p-type semiconductor layer (1) and an n-type titanium dioxide (TiO₂) layer (2) deposited on it, wherein a tunnel junction (4) is formed between the layers, **characterized in that** the TiO₂ layer (2) is directly grown by the ALD method onto the p-type semiconductor layer (1), whereas, to form the tunnel junction (4), several monoatomic TiO₂ layers and a monoatomic niobium (Nb) layer are alternatively grown onto the p-type semiconductor layer surface thus repeating the alternative growth an intended number of times necessary to reach high level of TiO₂ doping and completing the growth with TiO₂ layer, and then the grown layered structure is annealed in hydrogen atmosphere at temperature of at least 500°C to achieve high conductivity of TiO₂ and to obtain a tunnel junction.

3. Method according to claim 2, **characterized in that** to form the tunnel junction (4), firstly three monoatomic TiO₂ layers (5) are grown onto the p-type semiconductor layer (1), then a monoatomic Nb layer (6) is grown on them and five monoatomic TiO₂ layers (7) are grown on it, then a monoatomic Nb layer (6) is grown again, and said alternative growing of monoatomic TiO₂ layers (7) and monoatomic Nb layers (6) is repeated an intended number of times.

## Patentansprüche

1. Vorrichtung mit niedrigem Kontaktwiderstand, umfassend eine Schichtstruktur aus einer stark dotierten p-Typ Halbleiterschicht (1) und einer darauf hinterlegt n-Typ-Titandioxid (TiO₂)-Schicht (2), wobei ein Tunnelübergang (4) gebildet ist zwischen den Schichten, **dadurch gekennzeichnet, dass** die TiO₂-Schicht (2) direkt auf der p-Typ Halbleiterschicht (1) durch das Atomschichtabscheidung (ASA)-Verfahren abgeschieden wird, wobei ein Teil (3) der TiO₂-Schicht angrenzend an die p- Typ Halbleiter (1) während des Abscheidungsprozesses zusätzlich mit einer Niob-(Nb)-Donorverunreinigung dotiert wird, wodurch der Tunnelübergang (4) zwischen der n-Typ-TiO2-Schicht (3) und dem p-Typ-Halbleiter (1) gebildet wird.

2. Verfahren zur Herstellung eines Vorrichtung mit niedrigem Kontaktwiderstand, umfassend eine Schichtstruktur, die aus einer stark dotierten p-Typ Halbleiterschicht (1) und einer darauf abgeschiedenen n-Typ-Titandioxid (TiO₂)-Schicht (2) besteht, wobei ein Tunnelübergang vorgesehen ist (4) zwischen den Schichten gebildet wird, **dadurch gekennzeichnet, dass** die TiO₂-Schicht (2) durch das ASA-Verfahren direkt auf die p-Typ Halbleiterschicht (1) aufgewachsen wird, während zur Bildung des Tunnelübergangs (4) mehrere monoatomare TiO₂ Schichten und eine Schicht aus monoatomarem Niob (Nb) werden abwechselnd auf die Oberfläche der Halbleiterschicht vom p-Typ aufgewachsen, wodurch das alternative Aufwachsen so oft wiederholt wird, wie es zum Erreichen eines hohen TiO₂-Dotierungsniveaus erforderlich ist, und das Aufwachsen mit der TiO₂-Schicht abgeschlossen wird, und dann das Aufwachsen Schichtstruktur wird in einer Wasserstoffatmosphäre bei einer Temperatur von mindestens 500°C getempert, um eine hohe Leitfähigkeit von TiO₂ zu erreichen und einen Tunnelübergang zu erhalten.

3. Verfahren nach Patentansprücke 2, **dadurch gekennzeichnet, dass** zur Bildung des Tunnelübergangs (4) zuerst drei monoatomare TiO₂-Schichten (5) auf die p-Typ Halbleiterschicht (1) aufgewachsen werden, dann eine monoatomare Nb-Schicht (6) aufgewachsen und fünf monoatomare TiO₂ -Schichten (7) darauf aufgewachsen werden, dann wird erneut eine monoatomare Nb-Schicht (6) aufgewachsen, und das abwechselnde Aufwachsen von monoatomaren TiO₂ -Schichten (7) und monoatomaren Nb-Schichten (6) wird eine beabsichtigte Anzahl von Malen wiederholt.

## Revendications

1. Dispositif à résistance de contact faible constitué d'une structure en couches composée d'une couche semi-conductrice de type p fortement dopée (1) et d'une couche de dioxyde de titane (TiO2) de type n (2) déposée dessus, où une jonction tunnel (4) est formée entre les couches, **caractérisé en ce que** la couche de TiO2 (2) est directement déposée sur la couche semi-conductrice de type p (1) par un procédé de dépôt par couche atomique (ALD), où une partie (3) de la couche de TiO2 adjacente à la ladite surface du semi-conducteur de type p (1) est dopée en plus avec une impureté donneuse de niobium (Nb) pendant le processus de dépôt, formant ainsi une jonction tunnel (4) entre la couche de TiO2 de type n (3) et le semi-conducteur de type p (1).

2. Procédé de production d'un dispositif à résistance de contact faible constitué d'une structure en couches composée d'une couche semi-conductrice de type p fortement dopée (1) et d'une couche de dioxyde de titane (TiO2) de type n (2) déposée dessus, où une jonction tunnel (4) est formée entre les couches, **caractérisé en ce que** la couche de TiO2 (2) est directement développée par le procédé ALD sur la couche semi-conductrice de type p (1), tandis que, pour former la jonction tunnel (4), plusieurs couches monoatomiques de TiO2 et une couche monoatomique de niobium (Nb) sont alternativement développées sur la surface de la couche semi-conductrice de type p, répétant ainsi le développement alterné le nombre de fois prévu nécessaire pour atteindre un niveau élevé de dopage de TiO2 et achever le développement avec la couche de TiO2, puis la structure en couches développée est recuite dans une atmosphère d'hydrogène à une température d'au moins 500°C pour atteindre une conductivité élevée de TiO2 et pour obtenir une jonction tunnel.

3. Procédé selon la revendication 2, **caractérisé en ce que** pour former la jonction tunnel (4), trois couches monoatomiques de TiO2 (5) sont d'abord développées sur la couche semi-conductrice de type p (1), puis une couche monoatomique de Nb (6) est développée dessus et cinq couches monoatomiques de TiO2 (7) sont développées sur celle-ci, puis une couche monoatomique de Nb (6) est à nouveau développée, et ledit développement alterné de couches monoatomiques de TiO2 (7) et de couches monoatomiques de Nb (6) est répété un nombre de fois prévu.
